# EUROPEAN PATENT SPECIFICATION

(11) **EP 3 174 102 B1**
(45) Date of publication and mention of the grant of the patent: **28.09.2022**
(21) Application number: 15196730.4
(22) Date of filing: 27.11.2015
(51) Int. Cl.: H01L 29/778, H01L 21/338, H01L 29/417, H01L 29/45, H01L 29/423, H01L 29/20, H01L 29/40

(54) **SEMICONDUCTOR DEVICE AND METHOD OF MAKING A SEMICONDUCTOR DEVICE**
HALBLEITERBAUELEMENT UND VERFAHREN ZUR HERSTELLUNG EINES HALBLEITERBAUELEMENTS
DISPOSITIF DE SEMI-CONDUCTEUR ET PROCÉDÉ DE PRODUCTION D'UN TEL DISPOSITIF

(43) Date of publication of application: 31.05.2017
(73) Proprietor: Nexperia B.V., 6534 AB Nijmegen (NL)
(72) Inventor: Hurkx, Godefridus Adrianus Maria, Redhill, Surrey RH1 1SH (GB); Donkers, Johannes Josephus Theodorus Marinus, Redhill, Surrey RH1 1SH (GB); Sonsky, Jan, Redhill, Surrey RH1 1SH (GB); Croon, Jeroen Antoon, Redhill, Surrey RH1 1SH (GB)
(74) Representative: Pjanovic, Ilija

(56) References cited:
- US-A1- 2008 284 022
- US-A1- 2013 248 874
- CHUNHUA ZHOU ET AL: "Self-protected GaN power devices with reverse drain blocking and forward current limiting capabilities", POWER SEMICONDUCTOR DEVICES&IC'S (ISPSD), 2010 22ND INTERNATIONAL SYMPOSIUM ON, IEEE, PISCATAWAY, NJ, USA, 6 June 2010 (2010-06-06), pages 343-346, XP031729050, ISBN: 978-1-4244-7718-0

## Description

### BACKGROUND

The present specification relates to a semiconductor device and to a method of making a semiconductor device.

In recent years, GaN/AlGaN High Electron Mobility Transistors (HEMTs) and GaN/AlGaN Schottky diodes have drawn a lot of attention regarding their potential to replace Si or SiC for use as high voltage (HV) devices.

A GaN/AlGaN HEMT typically includes a substrate having an AlGaN layer located on a number of GaN layers. A gate, source and drain are located above the AlGaN layer. During operation, current flows between drain and source via a two-dimensional electron gas (2DEG) that is formed at the interface between the AlGaN layer and an upper GaN layer. Switch-off is achieved by applying a suitable voltage to the gate, such that the 2DEG at the interface between the AlGaN layer and the uppermost GaN layer disappears. The gate may be a Schottky contact or may comprise a gate electrode that is isolated by a dielectric layer (such devices are referred to as Metal Insulator Semiconductor High Electron Mobility Transistors (MISHEMTs).

A GaN/AlGaN Schottky diodes may be similarly constructed, but with two contacts (including a Schottky contact forming an anode and an ohmic contact forming a cathode of the device) instead of three.

Both the HEMT and the Schottky diode suffer from the problem that the on-state resistance under dynamic (e.g. switching, pulsed, RF) conditions may be significantly higher than under DC conditions.

US2013248874 relates to a nitride semiconductor device which includes a foundation layer, a semiconductor stacked body provided on the foundation layer and including a nitride semiconductor, a source electrode and a drain electrode provided on the semiconductor stacked body, and a gate electrode provided on the semiconductor stacked body and provided between the source electrode and the drain electrode.

US2008284022 relates to semiconductor devices utilizing nitride-based compound semiconductor and a method for manufacturing the same.

Chunhua Zhou et al: "Self-protected GaN power devices with reverse drain blocking and forward current limiting capabilities", Power semiconductor devices & IC's (ISPSD), 2010 22nd International Symposium on IEEE, Piscataway, NJ, USA, 6 June 2010, pages 343-346 relates to self-protected GaN power devices with reverse drain blocking and forward current limiting capabilities.

### SUMMARY

According to an aspect of the present disclosure, there is provided a semiconductor device comprising:
a substrate having an AlGaN layer located on a GaN layer for forming a two dimensional electron gas at an interface between the AlGaN layer and the GaN layer; and
a plurality of contacts, wherein at least one of the contacts comprises:
an ohmic contact portion located on a major surface of the substrate, wherein the ohmic contact portion comprises a first electrically conductive material; and
a trench extending down into the substrate from the major surface, wherein the trench passes through the AlGaN layer and into the GaN layer, wherein the trench is at least partially filled with a second electrically conductive material, and wherein the second electrically conductive material is a different electrically conductive material to the first electrically conductive material. The semiconductor device further comprises a High Electron Mobility Transistor "HEMT" comprising a gate contact located between a source contact and a drain contact, wherein said at least one of the contacts is the drain contact of the HEMT. The device further comprises at least one island located between the drain and the gate, wherein each island includes a trench extending down into the substrate from the major surface, wherein the trench passes through the AlGaN layer and into the GaN layer, wherein the trench is at least partially filled with said second electrically conductive material.

According to another aspect of the present disclosure, there is provided a method of making a semiconductor device, the method comprising:
providing a substrate having an AlGaN layer located on a GaN layer for forming a two dimensional electron gas at an interface between the AlGaN layer and the GaN layer; and
forming a plurality of contacts of the device, wherein forming at least one of said contacts comprises:
depositing a first electrically conductive material on a major surface of the substrate to form an ohmic contact portion;
forming a trench extending down into the substrate from the major surface, wherein the trench passes through the AlGaN layer and into the GaN layer; and
at least partially filling the trench with a second electrically conductive material, wherein the second electrically conductive material is a different electrically conductive material to the first electrically conductive material. The semiconductor device comprises a High Electron Mobility Transistor (HEMT). The method further comprises a step of forming a gate contact of the HEMT located between a source contact and a drain contact of the HEMT, wherein said at least one of the contacts is the drain contact of the HEMT. The method further comprises forming at least one island located between the drain contact and the gate contact by forming one or more trenches extending down into the substrate from the major surface, wherein each trench passes through the AlGaN layer (8) and into the GaN layer and at least partially filling each trench with said second electrically conductive material.

The provision of a contact having a trench that extends down into the GaN layer of the device can provide a leakage path for holes in the GaN layer to exit the device through the contact, which lowers the on state resistance of the device under dynamic (e.g. switching, pulsed, RF) conditions. This leakage path can short a pn-junction formed between the two dimensional electron gas ("2DEG") and the GaN layer.

In accordance with the invention, the first and second electrically conductive materials are different materials, and they are chosen independently to optimise the performance of the contact of the device. The first electrically conductive material is chosen to make a good ohmic contact. The second electrically conductive material that at least partially fills the trench is chosen so that it forms a low resistance contact with the GaN layer. In this respect, it is noted that a material that makes a good ohmic contact is suitable for use as the first electrically conductive material, but is not suitable for use as the second electrically conductive material, as it forms a local n+ region around the trench. This n+ region forms a reverse biased pn junction with the p- type GaN layer located around the trench, presenting a barrier to the flow of holes. Similarly, an electrically conductive material that is suitable for forming a low resistance path for holes is not suitable for forming an ohmic contact portion of the device.

In some embodiments, the at least one contact has a resistivity lower than approximately le9 Ω.mm. Using a typical width of the trench of 1 µm, this requirement is equivalent to a specific contact resistance lower than 10 Ωcm².

In one embodiment, the at least one contact includes a central part aligned with the trench. This central part is at least partially filled with the second electrically conductive material. The central part is substantially surrounded by the ohmic contact portion when viewed from above the major surface. Such a contact is conveniently manufactured in a manner that allows alignment of the trench relative to the ohmic contact portion (e.g. for producing a substantially symmetrical contact). For instance, a contact of this kind is manufactured by initially depositing the first electrically conductive material of the ohmic contact portion, and then removing at least part of the first electrically conductive material to form an opening in the ohmic contact portion. The opening exposes a part of the major surface beneath the contact. The method further includes forming a trench in the part of the major surface that is exposed by the opening in the ohmic contact portion. The trench and the opening in the ohmic contact portion is then at least partially filled with the second electrically conductive material. In some examples, the second electrically conductive material take the form of a layer that lines the trench. The layer of the second electrically conductive material also lines the opening in the ohmic contact portion. In such examples, a further electrically conductive material (e.g. Al) is used to fill the remainder of the trench and/or the opening in the ohmic contact portion.

A single contiguous portion of the second electrically conductive material formsthe central part and at least partially fill the trench. This allows for an uninterrupted path for holes between the GaN layer and the top of the contact. The single contiguous portion takes the form of a layer as noted above, or alternatively completely fills the trench and the central part.

The substrate further includes a GaN cap layer located on the AlGaN layer. The trench of the at least one contact passes through the GaN cap layer.

The device is a High Electron Mobility Transistor (HEMT) comprising a gate contact located between a source contact and a drain contact. The at least one of the contacts is a drain contact of the HEMT. The HEMT can be a MISHEMT having an insulated gate. The gate contact of the HEMT comprises the second electrically conductive material. This allows the number of deposition steps required to manufacture the device to be reduced, since a single deposition step is used to form the gate or anode of the HEMT and the second electrically conductive material that at least partially fills the trench.

At least one island is located between the drain contact and the gate contact. Each island includes a trench extending down into the substrate from the major surface. The trench passes through the AlGaN layer and into the GaN layer. The trench is at least partially filled with the second electrically conductive material. The islands provide additional paths for holes to exit the device. Since the trenches of the islands are at least partially filled with the second electrically conductive material, the generation of a reverse biased pn junction of the kind described above, which otherwise forms a significant barrier to the flow of holes out of the device from the GaN layer, is avoided. The islands are connected to the drain contacts of the device. The islands are formed during manufacture of the device by forming one or more trenches extending down into the substrate from the major surface, wherein each trench passes through the AlGaN layer and into the GaN layer. A deposition step is then used to at least partially fill each trench with the second electrically conductive material.

The first electrically conductive material can be an alloy of Ti/Al. The second electrically conductive material can be Ni, Pd, Pt or TiWN (in which the amount of N is varied).

A device of the kind described herein is used for Radio Frequency applications. For the purposes of this disclosure, Radio Frequencies (RF) are frequencies in the range 200MHz ≤ f ≤ 10GHz.

For power switching operations, the operating frequency of a device of the kind described herein is in the range 10kHz ≤ f ≤ 10MHz.

For the purposes of this disclosure, the electron mobility in a High Electron Mobility Transistor (HEMT) is in the range 1000-3000 cm^2/V/s or in the range 1000-2000 cm^2/V/s.

### BRIEF DESCRIPTION OF THE DRAWINGS

Embodiments of this disclosure will be described hereinafter, by way of example only, with reference to the accompanying drawings in which like reference signs relate to like elements and in which:
Figure 1 shows a semiconductor device according to an embodiment of this disclosure;
Figure 2 shows a semiconductor device according to another embodiment of this disclosure;
Figures 3A to 3D show a method of making a semiconductor device incorporating a contact of the kind shown in Figure 1;
Figures 4A to 4D show a method of making a semiconductor device incorporating a contact of the kind shown in Figure 2; and
Figures 5A to 5D show a method of making a semiconductor device according to a further embodiment of this disclosure. Only the method and the semiconductor device shown in Figures 5A to 5D are covered by the claims.

### DETAILED DESCRIPTION

Embodiments of this disclosure are described in the following with reference to the accompanying drawings.

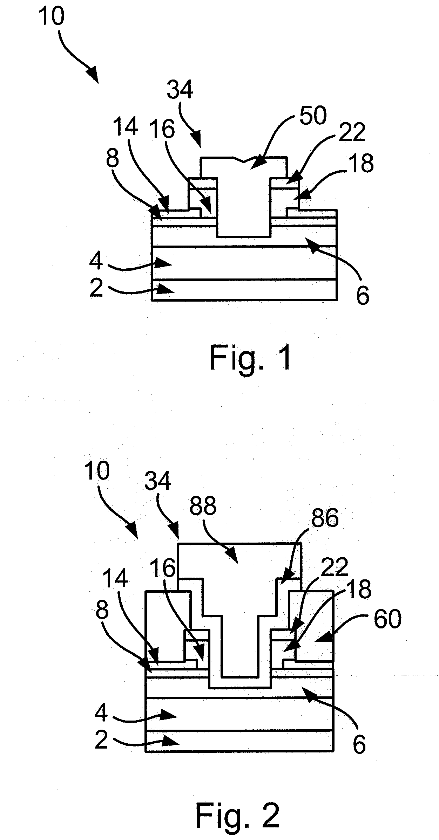

Figure 1 shows a semiconductor device 10 according to an embodiment of this disclosure.

The device includes a substrate 2. The substrate 2 may, for instance, be a silicon substrate, although it is also envisaged that the substrate 2 may comprise a ceramic, glass, SiC or sapphire. The substrate 2 has an AlGaN layer 8 located on a GaN layer 6. In use, a two dimensional electron gas or "2DEG" forms at an interface between the AlGaN layer and the GaN layer. Conduction of a current within the 2DEG forms the basis of operation of the device 10.

In this example, a number of buffer layers 4 comprising e.g. GaN and AlGaN may be located between the GaN layer and the underlying part of the substrate 2. These buffer layers 4 may form a super lattice acting as a stress relief region between the GaN layer 6 and the underlying part of the substrate 2.

In some examples, a GaN cap layer may be located on the AlGaN layer 8 (not shown in the Figures). A dielectric layer 14 may be provided on the AlGaN layer 8 (or on the GaN cap layer, if one is present). This dielectric layer may act as a passivation layer and/or may form a gate dielectric for the device 10 in the case of a MISHEMT. The dielectric layer 14 may, for instance, comprise SiN, SiOx or AlOx.

The device 10 includes a plurality of contacts, one of which is shown in Figure 1. The device 10 may be a High Electron Mobility Transistor (HEMT) having a source contact, a drain contact and a gate contact. The gate contact of the HEMT may be a Schottky contact, or alternatively may be an insulated gate (accordingly, the HEMT may be a Metal Insulator Semiconductor High Electron Mobility Transistor (MISHEMT)). The contact 34 shown in Figure 1 may be a drain contact of the HEMT. In other examples, the device 10 may be a Schottky diode having an anode and a cathode. The contact 34 shown in Figure 1 may be a cathode of the Schottky diode, the anode of the Schottky diode being formed of a Schottky contact.

The contact 34 shown in Figure 1 includes an ohmic contact portion 18. The ohmic contact portion 18 may be located on a major surface of the substrate 2. For instance, the ohmic contact portion 18 may be located on a surface of the AlGaN layer 8 (as is shown in Figure 1) or may be located on the surface of a GaN cap layer on the AlGaN layer 8, if one is present. The ohmic contact portion 18 may make a good ohmic contact to allow current flowing within the 2DEG at the interface between the AlGaN layer 8 and the GaN layer 6 to enter and/or exit the device 10 through the contact 34.

The ohmic contact portion 18 comprises a first electrically conductive material that may be located on the major surface of the substrate 2. In some examples, it is envisaged that the contact 34 may be a recessed contact, in which the ohmic contact portion 18 extends through an opening in the AlGaN layer 8, thereby to directly contact the underlying GaN layer 6.

A layer 22 may be located on the ohmic contact portion 18. The first electrically conductive material of the ohmic contact portion 18 may, for instance, comprise Ti/Al. The layer 22 may, for instance, comprise TiW(N). The layer 22 may function as a diffusion barrier during manufacture of the device 10.

The contact 34 also includes a trench. The trench may extend down into the substrate 2 of the device 10 from the major surface upon which ohmic contact portion 18 is located (e.g. this may be the surface of the AlGaN layer 8 or the surface of a GaN cap layer, if one is present). In particular, and as shown in the example of Figure 1, the trench passes through the AlGaN layer 8 (and any GaN cap layer) and into the GaN layer 6. This may allow the material filling the trench (as described below) to make direct contact with the GaN layer 6, for allowing holes located in the GaN layer 6 to pass freely into the contact 34. In the present example, the trench extends only partially into the GaN layer 6, although it is also envisaged that the trench may extend through the GaN layer 6 (e.g. to extend into the layers 4).

The trench is at least partially filled with a second electrically conductive material 50. The second electrically conductive material 50 may also at least partially fill (or, as shown in Figure 1, completely fill) a central part of the contact 34 that is substantially surrounded by the ohmic contact portion. As will be described below, the configuration and location of the central part of the contact 34 may allow for convenient manufacture of the device 10. A portion of the second electrically conductive material 50 may be located above the ohmic contact portion 18. For instance, in the example of Figure 1, a portion of the electrically conductive material 50 extends over an upper surface of the layer 22.

The trench that extends down into the GaN layer 6 of the device 10 can provide a leakage path for holes in the GaN layer 6 to exit the device 10 through the contact 34, which may lower the on state resistance of the device under dynamic (e.g. switching, pulsed, RF) conditions. This leakage path may short a pn-junction formed between the two dimensional electron gas ("2DEG") and the GaN layer 6. Moreover, in accordance with embodiments of this disclosure, the second electrically conductive material 50, which at least partially fills the trench, may be chosen so that a pn-junction is not formed at an interface between the second electrically conductive material 50 and the GaN of the GaN layer 6 (e.g. at the sidewalls and/or base of the trench). Such a pn junction may otherwise hinder the connection between the contact 34 and GaN of the GaN layer 6, inhibiting the flow of holes exiting the device 10 through the contact 34. Accordingly, the second electrically conductive material 50 may be chosen so as to lower the on state resistance of the device under dynamic (e.g. switching, pulsed, RF) conditions.

The second electrically conductive material is a different electrically conductive material to the first electrically conductive material. These materials may be chosen independently, to optimise the performance of the contact 34 of the device 10.

The first electrically conductive material, which forms the ohmic contact portion 18 may be chosen according to its suitability to make a good ohmic contact to the 2DEG. On the other hand, the second electrically conductive material 50 that at least partially fills the trench may be chosen so that it forms a low resistance contact with the GaN layer 6 (in particular, it may be chosen such that a pn junction may not form at the interface between the second electrically conductive material 50 and the GaN of the GaN layer 6, as noted above).

A material that makes a good ohmic contact may be suitable for forming the ohmic contact portion, but may not be suitable for use as the second electrically conductive material, as it may form a local n+ region in the part of the GaN layer 6 that surrounds the trench. This n+ region may form a reverse biased pn junction with the GaN layer 6 (which is p-type). The pn junction may surround the trench, thereby presenting a barrier to the flow of holes, as noted previously. Similarly, an electrically conductive material that is suitable for forming a low resistance path for holes to enter the contact 34 from the GaN layer 6 through the trench may not be suitable for forming the ohmic contact portion of the device 34.

As noted above, the first electrically conductive material, which may form the ohmic contact portion 18, may comprise an alloy of Ti/Al. This electrically conductive material is suited to the formation of an ohmic contact. However, were this material to be used to fill the trench of the contact 34, a reverse biased pn junction of the kind described above would form, presenting a barrier to the flow of holes into the contact 34. In accordance with an embodiment of this disclosure, the second electrically conductive material 50 may comprise Ni, Pd, Pt or TiW(N).

Figure 2 shows a semiconductor device 10 according to another embodiment of this disclosure. The device in Figure 2 is similar in some respects to the device 10 shown in Figure 1, and only the differences will be described in detail here.

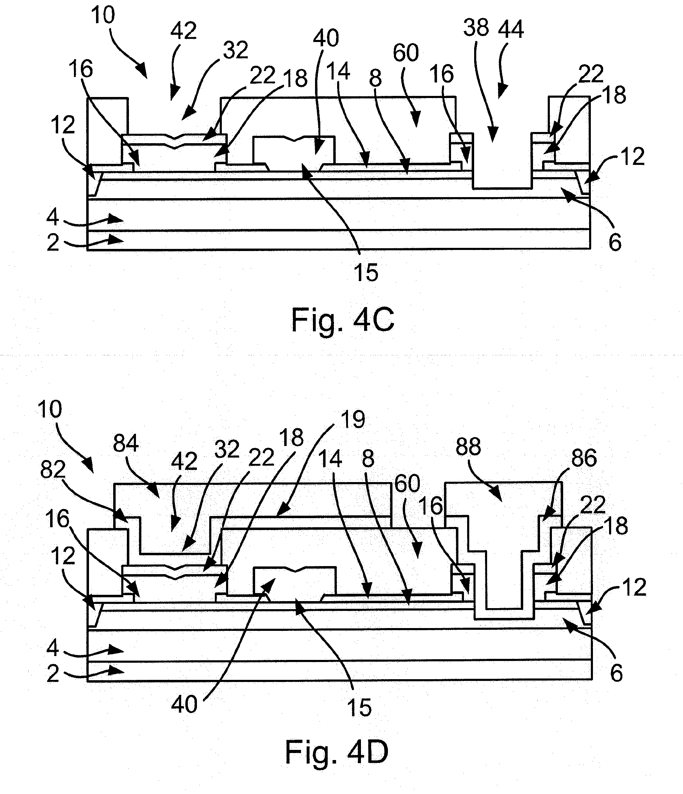

As shown in Figure 2, the contact 34 includes a trench that is at least partially filled with a second electrically conductive material. In this example, the second electrically conductive material 86 is provided in the form of a layer 86 that lines the trench. As shown in Figure 2, the layer 86 may also line sidewalls of an opening in the central part of the ohmic contact portion 18. The layer 86 of the second electrically conductive material may, in some examples, form a diffusion barrier elsewhere in the device 10 and/or may form part of a field plate elsewhere in the device 10, as will be explained below in relation to Figure 4D. In the present embodiment, the second electrically conductive material comprises TiW(N), although as already noted above, other materials, such as Ni, Pd or Pt are envisaged. In this example, a third electrically conductive material 88 may also be provided, for filling the part of the trench and/or central part of the contact 34 that is not filled with the second electrically conductive material. The third electrically conductive material may, for instance, comprise Al.

The example contact 34 in Figure 2 may also be a recessed contact as noted above in relation to Figure 1, in which the ohmic contact portion 18 extends through an opening in the AlGaN 8 layer, thereby to directly contact the underlying GaN layer 6.

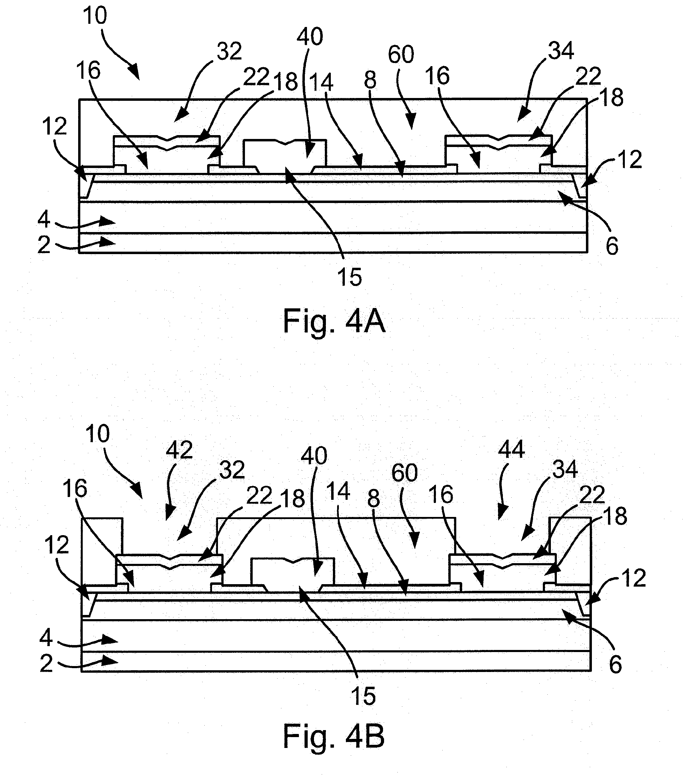

The example in Figure 2 may also include a dielectric layer 60, the composition and purpose of which will be described below in relation to Figures 4A to 4D.

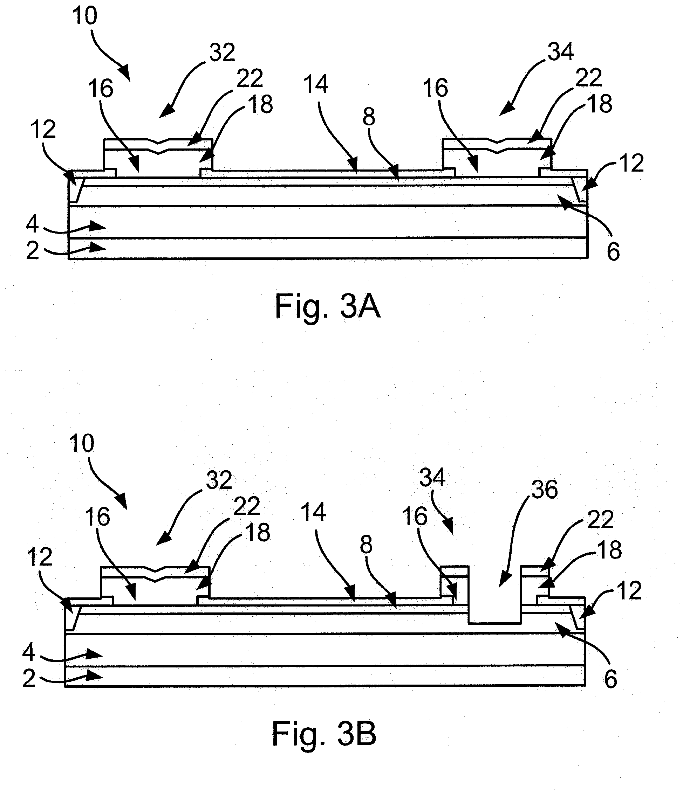

Figures 3A to 3D show a method of making a semiconductor device according to an embodiment of this disclosure. In this example, the device 10 comprises a HEMT having a Schottky gate contact, although it will be appreciated that processes similar to that described here may also be used to form a MISHEMT or Schottky diode. The method of Figures 3A to 3D may be used to make a device 10 including at least one contact of the kind shown in, for instance, Figure 1. In this example, the contact of Figure 1 forms a drain contact 34 of the device 10 to be manufactured.

In a first step, as shown in Figure 3A, the method may include providing a substrate 2. The substrate 2 may be of the kind described above in relation to Figure 1.

The substrate 2 may, for instance, be a silicon substrate, although it is also envisaged that the substrate 2 may comprise a ceramic or glass. The substrate 2 has an AlGaN layer 8 located on a GaN layer 6. A number of buffer layers 4 comprising GaN may be located between the GaN layer and the underlying part of the substrate 2. As noted previously, these buffer layers 4 may form a super lattice that matches the lattice of the GaN layer 6 to underlying part of the substrate 2. In some examples, a GaN cap layer may be located on the AlGaN layer 8 (not shown in the Figures). In the present example, isolation regions 12 (e.g. trenches filled with dielectric or implanted regions) are provided for isolating the HEMT from other electrical devices on the substrate 2.

A dielectric layer 14 may be deposited on a major surface of the substrate, e.g. on a surface of the AlGaN layer 8 or any GaN cap layer that may be provided on the AlGaN layer 8. As noted previously, the dielectric layer 14 may act as a passivation layer. The dielectric layer 14 may comprise, for instance, SiN, SiOx or AlOx.

Next, openings 16 may be formed in the dielectric layer 14. These openings 16 may allow access to the underlying layers, such as the AlGaN layer 8 for the source and drain contacts of the device. The openings 16 may be formed by etching.

After formation of the opening 16, a first electrically conductive material may be deposited and patterned to form the ohmic contact portion 18 of a source contact 32 and a drain contact 34 of the device 10. This step may also include depositing and patterning layers 22 on the source contact 32 and drain contact 34, which may act as a diffusion barrier. As noted previously, the first electrically conductive material that forms the ohmic contact portion 18 of the source contact 32 and the drain contact 34 may comprise, for instance, comprise Ti/Al, while the layers 22 of the source contact 32 and the drain contact 34 may, for instance, comprise TiW(N).

In a next step, shown in Figure 3B, a masking and etching step (e.g. a dry etch) may be used to etch a trench 36 in the drain contact 34. The trench 36 may be located in a central part of the drain contact 34. The trench 36 may extend through the ohmic contact portion 18 and the layer 22. The trench 36 extends through the AlGaN layer 8 and any GaN cap layer that may be located on the AlGaN layer 8. The trench 36 further extends into the GaN layer 6.

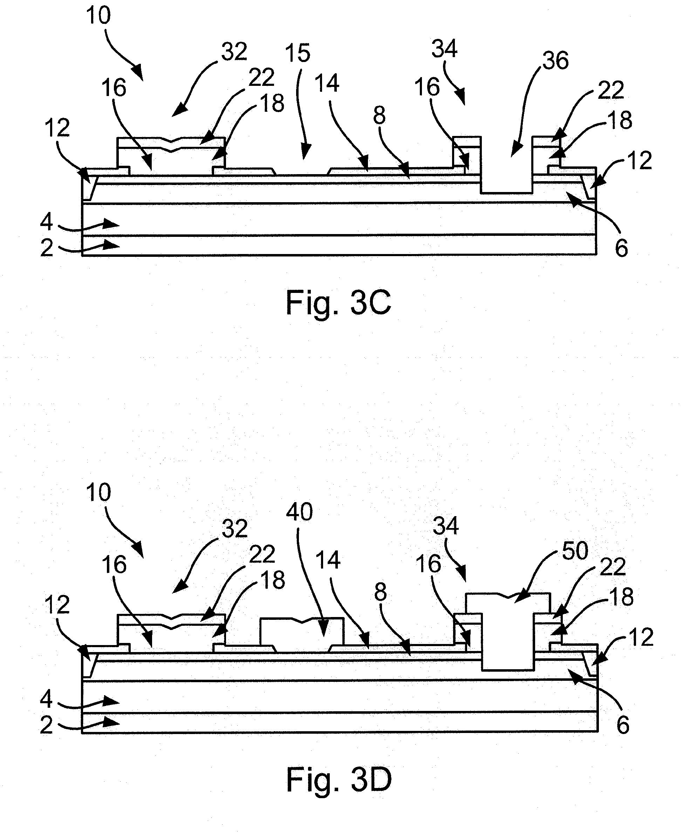

In a next step shown in Figure 3C, a further opening 15 may be formed (e.g. by etching) in the dielectric layer 14, to allow a Schottky gate contact of the device 10 to be formed. The opening 15 may be located between the source contact 32 and the drain contact 34 on the major surface of the substrate 2.

In a next step shown in Figure 3D, a second electrically conductive material may be deposited and patterned. As noted previously, the second electrically conductive material may, for instance, comprise Ni, Pd, Pt or TiW(N).

The deposition and patterning of the second electrically conductive material may result in a drain contact 34 that is of the kind described above in relation to Figure 1. In the present example, the second electrically conductive material is also used to form the Schottky gate electrode 40 of the HEMT of the device 10. In this way, the of process steps required to manufacture the device 10 may be reduced, since separate deposition steps need not be provided for forming the second electrically conductive material 50 of the contact 34 and the Schottky gate electrode 40. Nevertheless, if it is still desired to use a different electrically conductive materials for the Schottky gate electrode 40 and the contact 34, then different deposition step may still be used.

Figures 4A to 4D show a method of making a semiconductor device according to another embodiment of this disclosure. In this example, the device 10 comprises a HEMT having a Schottky gate contact, although it will be appreciated that processes similar to that described here may also be used to form a MISHEMT or Schottky diode. The method of Figures 4A to 4D may be used to make a device 10 including at least one contact of the kind shown in, for instance, Figure 2. In this example, the contact of Figure 2 forms a drain contact 34 of the device 10 to be manufactured.

In a first step, as shown in Figure 4A, the method may include providing a substrate 2. The substrate 2 may be of the kind described above in relation to Figures 1 to 3.

The substrate 2 may, for instance, be a silicon substrate, although it is also envisaged that the substrate 2 may comprise a ceramic or glass. The substrate 2 has an AlGaN layer 8 located on a GaN layer 6. A number of buffer layers 4 comprising GaN may be located between the GaN layer and the underlying part of the substrate 2. As noted previously, these buffer layers 4 may form a super lattice that matches the lattice of the GaN layer 6 to underlying part of the substrate 2. In some examples, a GaN cap layer may be located on the AlGaN layer 8 (not shown in the Figures). In the present example, the substrate 2 includes isolation regions 12 (e.g. trenches filled with dielectric) for isolating the HEMT from other parts of the substrate 2.

A dielectric layer 14 may be deposited on a major surface of the substrate, e.g. on a surface of the AlGaN layer 8 or any GaN cap layer that may be provided on the AlGaN layer 8. As noted previously, the dielectric layer 14 may act as a passivation layer. The dielectric layer 14 may comprise, for instance, SiN, SiOx or AlOx.

Next, openings 16 may be formed in the dielectric layer 14. These openings 16 may allow access to the underlying layers, such as the AlGaN layer 8 for the source and drain contacts of the device. The openings 16 may be formed by etching.

After formation of the opening 16, a first electrically conductive material may be deposited and patterned to form the ohmic contact portions 18 of a source contact 32 and a drain contact 34 of the device 10. This step may also include depositing and patterning layers 22 on the source contact 32 and drain contact 34. As noted previously, the first electrically conductive material that forms the ohmic contact portions 18 of the source contact 32 and the drain contact 34 may comprise, for instance, comprise Ti/Al, while the layers 22 of the source contact 32 and the drain contact 34 may, for instance, comprise TiW(N).

Next, a further opening 15 may be formed (e.g. by etching) in the dielectric layer 14, to allow a Schottky gate contact of the device 10 to be formed. The opening 15 may be located between the source contact 32 and the drain contact 34 on the major surface of the substrate 2. After the opening 15 is formed, an electrically conductive material may be deposited and patterned to form the Schottky gate contact 40 of the HEMT. The electrically conductive material of the Schottky gate contact 40 may, for instance, comprise Ni.

Next a dielectric layer 60 may be deposited, e.g. by Plasma Enhanced Chemical Vapour Deposition (PECVD). The layer 60 may, for instance, comprise SiN. The layer 60 may have a thickness of around 100nm.

In a next step shown in Figure 4B, openings 42, 44 may be formed (e.g. by etching) in the layer 60, to obtain access to the underlying source contact 32 and the drain contact 34.

In a next step shown in Figure 4C, a masking and etching step (e.g. a dry etch) may be used to etch a trench 38 in the drain contact 34. The trench 38 may be located in a central part of the drain contact 34. The trench 36 may extend through the ohmic contact portion 18 and the layer 22. The trench 36 may further extend through the AlGaN layer 8 and any GaN cap layer that may be located on the AlGaN layer 8. The trench 36 may further extend into the GaN layer 6.

In a next step, a layer 86 of a second electrically conductive material may be deposited. In this example, the second electrically conductive material comprises TiW(N), although in other examples, the second electrically conductive material may, for instance, comprise Ni, Pd or Pt. The layer 86 of the second electrically conductive material may have a thickness of around 100nm. The layer 86 of the second electrically conductive material may line the trench 38 and/or sidewalls of the central part of the contact. The layer 86 may also cover an upper surface of the layer 22 of the drain contact 34. The layer 86 may further cover an upper surface of the layer 22 of the source contact 32 and an upper surface of the layer 60.

Thereafter, a third electrically conductive material 88, such as Al, may be deposited on the layer 86. In some examples, around 1µm of the third electrically conductive material may be deposited on the layer 86. Note that in the present example, the Schottky gate electrode 40 may be of a different material to the second electrically conductive material.

After the second and third electrically conductive materials have been deposited, they may be patterned to result in the structure shown in Figure 4D. The second electrically conductive material may thus form a layer 86 that lines the trench in the drain contact 34 and may also form a layer 82 that covers an upper surface of the layer 22 of the source contact 32. A part 19 of the layer 82 may extend above the gate. The layer 82 may itself be covered by a portion 84 of the third electrically conductive material. The part 19 of the layer 82, and the overlying portion 84 may thus form a source field plate for the device 10. Note that the structure of the drain contact 34 in Figure 4D is of the kind described above in relation to Figure 2. Note that the dielectric layer 60 may serve to separate and isolate the part 19 of the layer 82 and the overlying portion 84 from the underlying parts of the device 10, such as the gate contact 40.

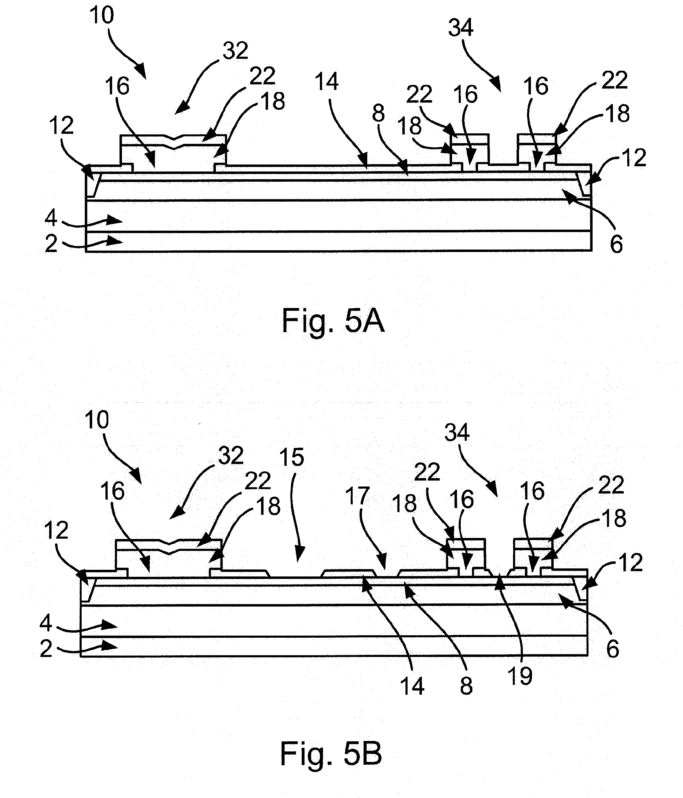

Figures 5A to 5D show a method of making a semiconductor device according to 2. an embodiment of the invention. In this example, the device 10 comprises a HEMT having a Schottky gate contact, although it will be appreciated that processes similar to that described here are used to form a MISHEMT or, in an example not covered by the claims, a Schottky diode. The contact of the HEMT that includes a trench of the kind described herein is the drain contact.

In a first step, as shown in Figure 5A, the method includes providing a substrate 2. The substrate 2 is of the kind described above in relation to Figures 1 to 4.

The substrate 2 is, for instance, a silicon substrate, although it is also envisaged that the substrate 2 comprises a ceramic or glass. The substrate 2 has an AlGaN layer 8 located on a GaN layer 6. A number of buffer layers 4 comprising e.g. GaN and AlGaN is located between the GaN layer and the underlying part of the substrate 2. As noted previously, these buffer layers 4 forms a super lattice that matches the lattice of the GaN layer 6 to underlying part of the substrate 2. In some examples, a GaN cap layer is located on the AlGaN layer 8 (not shown in the Figures). In the present example, isolation regions 12 (e.g. trenches filled with dielectric or implanted regions) are provided for isolating the HEMT from other electrical devices on the substrate 2.

A dielectric layer 14 is deposited on a major surface of the substrate, e.g. on a surface of the AlGaN layer 8 or any GaN cap layer that is provided on the AlGaN layer 8. As noted previously, the dielectric layer 14 acts as a passivation layer. The dielectric layer 14 comprises, for instance, SiN, SiOx or AlOx.

Next, openings 16 are formed in the dielectric layer 14. These openings 16 allow access to the underlying layers, such as the AlGaN layer 8 for the source and drain contacts of the device. The openings 16 are formed by etching.

After formation of the openings 16, a first electrically conductive material is deposited and patterned to form the ohmic contact portions 18 of a source contact 32 and a drain contact 34 of the device 10. This step also includes depositing and patterning layers 22 on the source contact 32 and drain contact 34, as described previously. As also noted previously, the first electrically conductive material that forms the ohmic contact portions 18 of the source contact 32 and the drain contact 34 comprises, for instance, Ti/Al, while the layers 22 of the source contact 32 and the drain contact 34, for instance, comprise TiW(N).

In a next step shown in Figure 5B, further openings 15, 17 are formed (e.g. by etching) in the dielectric layer 14. The opening 15, as described in relation to previous embodiments, allows a Schottky gate contact of the device 10 to be formed. The opening 15 is located between the source contact 32 and the drain contact 34 on the major surface of the substrate 2. One or more openings 17 allows one of more islands to be formed between the gate contact and the drain contact of the device, as described in more detail below.

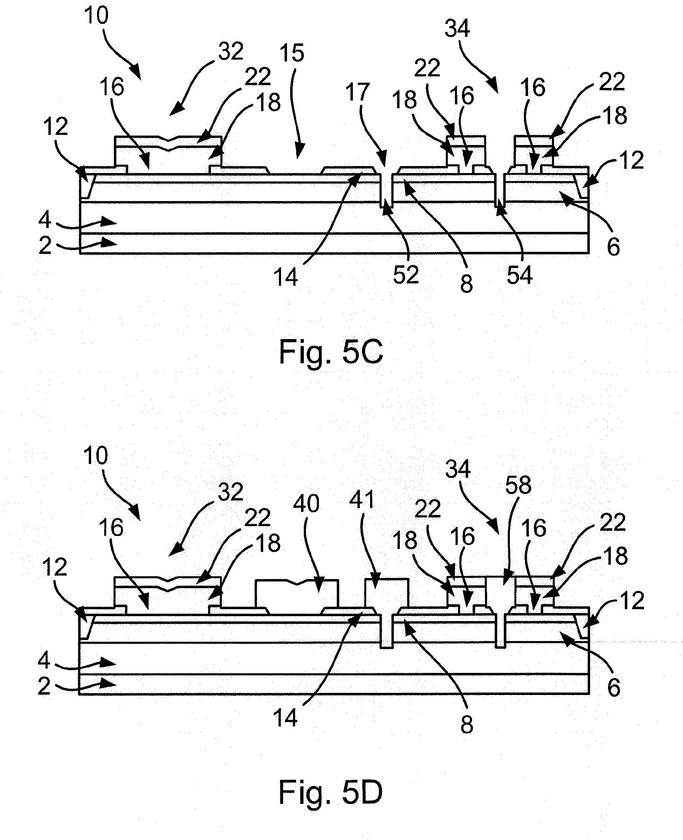

In a next step shown in Figure 5C, a masking and etching process is used to form a number of trenches. These trenches include a trench 54 that extends through the drain contact 34 and into the GaN layer 6 as described above in relation to the preceding embodiments. In the present example, one or more trenches 52 are etched through the one or more openings 17 in the dielectric layer 14. The trenches 52 extend down into the substrate 2 from the major surface thereof in a manner similar to that already described in relation to the trench 54 of the drain contact 34.

In a next step, a second electrically conductive material is deposited and patterned, resulting in the device shown in Figure 5D. In the present example, the second electrically conductive material comprises Ni, although as noted previously, it is envisaged that the second electrically conductive material comprises, for instance, Pd, Pt or TiW(N).

As can be seen in Figure 5D, the second electrically conductive material at least partially fills the trench 54 of the drain contact 34 (as indicated using reference numeral 58 in Figure 5D), resulting in a drain contact similar to the contacts described above in relation to the earlier embodiments. In some examples, the second electrically conductive material are provided in the form of a layer that lines the trench 54 as described above in relation to Figure 2.

Another part of the deposited and patterned second electrically conductive material, which is aligned with the opening 15 in the dielectric layer 14, forms a Schottky gate electrode 40 of the device 10.

A further part of the deposited and patterned second electrically conductive material at least partially fills each of the one or more trenches 52 described above in relation to Figure 5C. This results in the formation of one or more islands 41 located between the gate contact and the drain contact 34, each island including a trench extending down into the substrate 2 from the major surface, with each trench being at least partially filled with the second electrically conductive material. In examples where the second electrically conductive material is provided in the form of a layer as noted above, the layer also lines the trenches 52. The remainder of the trench 54 and/or the trenches 52 is filled with a third electrically conductive material such as Al.

As it is seen in Figure 5D, a part of the second electrically conductive material of each island 41 extends out of the trenches 52 and above the major surface of the substrate 2 (e.g. it extends over the surface of the dielectric layer 14). The islands 41 are electrically connected to the drain contact 32.

The islands 41 provide a further route for holes located in the GaN layer 6 to exit the device 10.

The islands 41 and their associated trenches 52, when viewed from above the major surface of the substrate 2 are shaped as dots or stripes. The islands are arranged in an array. For instance, the array comprises on or more rows of substantially equally spaced islands.

In each of the examples described above in relation to Figures 3 to 5, it is envisaged that the opening 15 in the dielectric layer are omitted, allowing a MISHEMT to be formed without necessarily requiring any other significant modification of the manufacturing process.

Accordingly, there has been described a semiconductor device and a method of making the same. The device includes a substrate having an AlGaN layer located on a GaN layer for forming a two dimensional electron gas at an interface between the AlGaN layer and the GaN layer. The device also includes a plurality of contacts. At least one of the contacts includes an ohmic contact portion located on a major surface of the substrate. The ohmic contact portion comprises a first electrically conductive material. The at least one of the contacts also includes a trench extending down into the substrate from the major surface. The trench passes through the AlGaN layer and into the GaN layer. The trench is at least partially filled with a second electrically conductive material. The second electrically conductive material is a different electrically conductive material to the first electrically conductive material.

Although particular embodiments of this disclosure have been described, it will be appreciated that many modifications/additions and/or substitutions may be made within the scope of the claims.

## Claims

1. A semiconductor device (10) comprising:
a substrate (2) having an AlGaN layer (8) located on a GaN layer (6) for forming a two dimensional electron gas at an interface between the AlGaN layer and the GaN layer; and
a plurality of contacts (34),
wherein at least one of the contacts comprises:
an ohmic contact portion (18) located on a major surface of the substrate, wherein the ohmic contact portion comprises a first electrically conductive material; and
a trench (36) extending down into the substrate from the major surface, wherein the trench passes through the AlGaN layer and into the GaN layer, wherein the trench is at least partially filled with a second electrically conductive material, and wherein the second electrically conductive material is a different electrically conductive material to the first electrically conductive material,
wherein the device further comprises:
a High Electron Mobility Transistor, HEMT, comprising a gate contact located between a source contact and a drain contact (34), wherein said at least one of the contacts is the drain contact of the HEMT;
**characterized in that**,
the device further comprises at least one island (41) located between the drain and the gate, wherein each island includes a trench extending down into the substrate from the major surface, wherein the trench passes through the AlGaN layer (8) and into the GaN layer (6), wherein the trench is at least partially filled with said second electrically conductive material.

2. The semiconductor device (10) of claim 1, wherein said at least one of the contacts includes a central part aligned with the trench, wherein the central part is at least partially filled with the second electrically conductive material and wherein the central part is substantially surrounded by the ohmic contact portion when viewed from above the major surface.

3. The semiconductor device (10) of claim 2, comprising a single contiguous portion of said second electrically conductive material at least partially filling the central part of the contact and the trench.

4. The semiconductor device (10) of claim 2 or claim 3, wherein said second electrically conductive material comprises a layer that lines at least the trench.

5. The semiconductor device (10) of any preceding claim, wherein the substrate (2) further includes a GaN cap layer located on the AlGaN layer (8), and wherein the trench of said at least one of the contacts passes through the GaN cap layer.

6. The semiconductor device (10) of claim 1, wherein the gate of the HEMT comprises said second electrically conductive material.

7. The semiconductor device (10) of any preceding claim, wherein the first electrically conductive material comprises an alloy of Ti/Al and/or wherein the second electrically conductive material comprises Ni, Pd, Pt or TiWN

8. A method of making a semiconductor device (10), the method comprising:
providing a substrate having an AlGaN layer (8) located on a GaN layer (6) for forming a two dimensional electron gas at an interface between the AlGaN layer and the GaN layer; and
forming a plurality of contacts of the device, wherein forming at least one of said contacts comprises:
depositing a first electrically conductive material on a major surface of the substrate to form an ohmic contact portion;
forming a trench extending down into the substrate from the major surface, wherein the trench passes through the AlGaN layer and into the GaN layer; and
at least partially filling the trench with a second electrically conductive material, wherein the second electrically conductive material is a different electrically conductive material to the first electrically conductive material;
and wherein the semiconductor device comprises a High Electron Mobility Transistor, HEMT, the method comprising:
forming a gate contact of the HEMT located between a source contact and a drain contact (34) of the HEMT, wherein said at least one of the contacts is the drain contact of the HEMT;
**characterized in that**,
the method further comprises forming at least one island (41) located between the drain contact (34) and the gate contact by:
forming one or more trenches extending down into the substrate from the major surface, wherein each trench passes through the AlGaN layer (8) and into the GaN layer (6); and
at least partially filling each trench with said second electrically conductive material.

9. The method of claim 8, comprising:
removing at least part of the first electrically conductive material of the at least one of said contacts to form an opening in the ohmic contact portion, wherein the opening exposes a part of the major surface;
forming the trench in the part of the major surface exposed by the opening in the ohmic contact portion; and
at least partially filling the trench and the opening in the ohmic contact portion with said second electrically conductive material.

10. The method of claim 9, wherein the part of the first electrically conductive material of the at least one of said contacts that is removed to form said opening in the ohmic contact portion comprises a central part of said contact, and wherein after said at least partially filling the trench and the opening in the ohmic contact portion with said second electrically conductive material, the central part is substantially surrounded by the ohmic contact portion (18) when viewed from above the major surface.

## Patentansprüche

1. Halbleitervorrichtung (10), die Folgendes umfasst:
ein Substrat (2) mit einer auf einer GaN-Schicht (6) liegenden AlGaN-Schicht (8) zum Bilden eines zweidimensionalen Elektronengases an einer Grenzfläche zwischen der AlGaN-Schicht und der GaN-Schicht; und
eine Vielzahl von Kontakten (34),
wobei mindestens einer der Kontakte Folgendes umfasst:
einen ohmschen Kontaktabschnitt (18), der auf einer Hauptoberfläche des Substrats liegt, wobei der ohmsche Kontaktabschnitt ein erstes elektrisch leitfähiges Material umfasst; und
einen Graben (36), der sich von der Hauptoberfläche in das Substrat herab erstreckt, wobei der Graben durch die AlGaN-Schicht und in die GaN-Schicht läuft, wobei der Graben mindestens teilweise mit einem zweiten elektrisch leitfähigen Material gefüllt ist, und wobei das zweite elektrisch leitfähige Material ein von dem ersten elektrisch leitfähigen Material verschiedenes elektrisch leitfähiges Material ist,
wobei die Vorrichtung ferner Folgendes umfasst:
einen High-Electron-Mobility-Transistor, HEMT, der einen zwischen einem Source-Kontakt und einem Drain-Kontakt (34) liegenden Gate-Kontakt umfasst,
wobei der mindestens eine der Kontakte der Drain-Kontakt des HEMT ist;
**dadurch gekennzeichnet, dass**
die Vorrichtung ferner mindestens eine zwischen dem Drain und dem Gate liegende Insel (41) umfasst, wobei jede Insel einen Graben umfasst, der sich von der Hauptoberfläche in das Substrat herab erstreckt, wobei der Graben durch die AlGaN-Schicht (8) und in die GaN-Schicht (6) läuft, wobei der Graben mindestens teilweise mit dem zweiten elektrisch leitfähigen Material gefüllt ist.

2. Halbleitervorrichtung (10) nach Anspruch 1, wobei der mindestens eine der Kontakte einen auf den Graben ausgerichteten mittigen Teil umfasst, wobei der mittige Teil mindestens teilweise mit dem zweiten elektrisch leitfähigen Material gefüllt ist, und wobei der mittige Teil bei Betrachtung von oberhalb der Hauptoberfläche im Wesentlichen von dem ohmschen Kontaktabschnitt umgeben ist.

3. Halbleitervorrichtung (10) nach Anspruch 2, umfassend einen einzelnen zusammenhängenden Abschnitt des zweiten elektrisch leitfähigen Materials, der den mittigen Teil des Kontakts und den Graben mindestens teilweise füllt.

4. Halbleitervorrichtung (10) nach Anspruch 2 oder Anspruch 3, wobei das zweite elektrisch leitfähige Material eine Schicht umfasst, die mindestens den Graben auskleidet.

5. Halbleitervorrichtung (10) nach einem der vorangehenden Ansprüche, wobei das Substrat (2) ferner eine auf der AlGaN-Schicht (8) liegende GaN-Deckschicht umfasst, und wobei der Graben des mindestens einen der Kontakte durch die GaN-Deckschicht läuft.

6. Halbleitervorrichtung (10) nach Anspruch 1, wobei das Gate des HEMT das zweite elektrisch leitfähige Material umfasst.

7. Halbleitervorrichtung (10) nach einem der vorangehenden Ansprüche, wobei das erste elektrisch leitfähige Material eine Legierung aus Ti/Al umfasst, und/oder wobei das zweite elektrisch leitfähige Material Ni, Pd, Pt oder TiWN umfasst.

8. Verfahren zum Herstellen einer Halbleitervorrichtung (10), wobei das Verfahren Folgendes umfasst:
Bereitstellen eines Substrats mit einer auf einer GaN-Schicht (6) liegenden AlGaN-Schicht (8) zum Bilden eines zweidimensionalen Elektronengases an einer Grenzfläche zwischen der AlGaN-Schicht und der GaN-Schicht; und
Bilden einer Vielzahl von Kontakten der Vorrichtung,
wobei das Bilden mindestens eines der Kontakte Folgendes umfasst:
Abscheiden eines ersten elektrisch leitfähigen Materials auf einer Hauptoberfläche des Substrats, um einen ohmschen Kontaktabschnitt zu bilden;
Bilden eines Grabens, der sich von der Hauptoberfläche in das Substrat herab erstreckt, wobei der Graben durch die AlGaN-Schicht und in die GaN-Schicht läuft; und
Füllen des Grabens mindestens teilweise mit einem zweiten elektrisch leitfähigen Material, wobei das zweite elektrisch leitfähige Material ein von dem ersten elektrisch leitfähigen Material verschiedenes elektrisch leitfähiges Material ist;
und wobei die Halbleitervorrichtung einen High-Electron-Mobility-Transistor, HEMT, umfasst, wobei das Verfahren Folgendes umfasst:
Bilden eines zwischen einem Source-Kontakt und einem Drain-Kontakt (34) des HEMT liegenden Gate-Kontakts des HEMT, wobei der mindestens eine der Kontakte der Drain-Kontakt des HEMT ist;
**dadurch gekennzeichnet, dass**
das Verfahren ferner das Bilden mindestens einer zwischen dem Drain-Kontakt (34) und dem Gate-Kontakt liegenden Insel (41) wie folgt umfasst:
Bilden eines oder mehrerer Gräben, die sich von der Hauptoberfläche in das Substrat herab erstrecken, wobei jeder Graben durch die AlGaN-Schicht (8) und in die GaN-Schicht (6) läuft; und
Füllen jedes Grabens mindestens teilweise mit dem zweiten elektrisch leitfähigen Material.

9. Verfahren nach Anspruch 8, das Folgendes umfasst:
Entfernen mindestens eines Teils des ersten elektrisch leitfähigen Materials des mindestens einen der Kontakte, um eine Öffnung in dem ohmschen Kontaktabschnitt zu bilden, wobei die Öffnung einen Teil der Hauptoberfläche freilegt;
Bilden des Grabens in dem von der Öffnung in dem ohmschen Kontaktabschnitt freigelegten Teil der Hauptoberfläche; und
Füllen des Grabens und der Öffnung in dem ohmschen Kontaktabschnitt mindestens teilweise mit dem zweiten elektrisch leitfähigen Material.

10. Verfahren nach Anspruch 9, wobei der Teil des ersten elektrisch leitfähigen Materials des mindestens einen der Kontakte, der entfernt wird, um die Öffnung in dem ohmschen Kontaktabschnitt zu bilden, einen mittigen Teil des Kontakts umfasst, und wobei nach dem Füllen des Grabens und der Öffnung in dem ohmschen Kontaktabschnitt mindestens teilweise mit dem zweiten elektrisch leitfähigen Material der mittige Teil bei Betrachtung von oberhalb der Hauptoberfläche von dem ohmschen Kontaktabschnitt (18) im Wesentlichen umgeben ist.

## Revendications

1. Dispositif semi-conducteur (10) comprenant :
un substrat (2) ayant une couche d'AlGaN (8) située sur une couche de GaN (6) pour former un gaz d'électrons bidimensionnel au niveau d'une interface entre la couche d'AlGaN et la couche de GaN ; et
une pluralité de contacts (34),
au moins l'un des contacts comprenant :
une partie contact ohmique (18) située sur une surface principale du substrat, la partie contact ohmique comprenant un premier matériau électriquement conducteur ; et
une tranchée (36) s'étendant dans le substrat à partir de la surface principale, la tranchée passant à travers la couche d'AlGaN et dans la couche de GaN, la tranchée étant au moins partiellement remplie d'un second matériau électriquement conducteur, et le second matériau électriquement conducteur étant un matériau électriquement conducteur différent du premier matériau électriquement conducteur,
le dispositif comprenant en outre :
un transistor à haute mobilité électronique, HEMT, comprenant un contact de grille situé entre un contact de source et un contact de drain (34),
ledit au moins l'un des contacts étant le contact de drain du HEMT ;
**caractérisé en ce que**,
le dispositif comprend en outre au moins un ilot (41) situé entre le drain et la grille, chaque ilot incluant une tranchée s'étendant dans le substrat à partir de la surface principale, la tranchée passant à travers la couche d'AlGaN (8) et dans la couche de GaN (6), la tranchée étant au moins partiellement remplie dudit second matériau électriquement conducteur.

2. Dispositif semi-conducteur (10) selon la revendication 1, dans lequel ledit au moins l'un des contacts inclut une partie centrale alignée avec la tranchée, la partie centrale étant au moins partiellement remplie du second matériau électriquement conducteur et la partie centrale étant sensiblement entourée par la partie contact ohmique lorsqu'elle est regardée depuis le dessus de la surface principale.

3. Dispositif semi-conducteur (10) selon la revendication 2, comprenant une unique partie contiguë dudit second matériau électriquement conducteur remplissant au moins partiellement la partie centrale du contact et de la tranchée.

4. Dispositif semi-conducteur (10) selon la revendication 2 ou la revendication 3, dans lequel ledit second matériau électriquement conducteur comprend une couche qui garnit au moins la tranchée.

5. Dispositif semi-conducteur (10) selon l'une quelconque des revendications précédentes, dans lequel le substrat (2) inclut en outre une couche de couverture de GaN située sur la couche d'AlGaN (8), et dans lequel la tranchée dudit au moins l'un des contacts passe à travers la couche de couverture de GaN.

6. Dispositif semi-conducteur (10) selon la revendication 1, dans lequel la grille du HEMT comprend ledit second matériau électriquement conducteur.

7. Dispositif semi-conducteur (10) selon l'une quelconque des revendications précédentes, dans lequel le premier matériau électriquement conducteur comprend un alliage de Ti/Al et/ou dans lequel le second matériau électriquement conducteur comprend du Ni, du Pd, du Pt ou du TiWN

8. Procédé de fabrication d'un dispositif semi-conducteur (10), le procédé comprenant les étapes consistant à :
fournir un substrat ayant une couche d'AlGaN (8) située sur une couche de GaN (6) pour former un gaz d'électrons bidimensionnel au niveau d'une interface entre la couche d'AlGaN et la couche de GaN ; et
former une pluralité de contacts du dispositif,
la formation d'au moins l'un desdits contacts comprenant les étapes consistant à :
déposer un premier matériau électriquement conducteur sur une surface principale du substrat pour former une partie contact ohmique ;
former une tranchée s'étendant dans le substrat depuis la surface principale, la tranchée passant à travers la couche d'AlGaN et dans la couche de GaN ; et
remplir au moins partiellement la tranchée avec un second matériau électriquement conducteur,
le second matériau électriquement conducteur étant un matériau électriquement conducteur différent du premier matériau électriquement conducteur ;
et le dispositif semi-conducteur comprenant un transistor à haute mobilité électronique, HEMT, le procédé comprenant l'étape consistant à :
former un contact de grille du HEMT situé entre un contact de source et un contact de drain (34) du HEMT,
ledit au moins l'un des contacts étant le contact de drain du HEMT ;
**caractérisé en ce que**,
le procédé comprend l'étape consistant en outre à former au moins un ilot (41) situé entre le contact de drain (34) et le contact de grille en :
formant une ou plusieurs tranchées s'étendant dans le substrat depuis la surface principale, chaque tranchée passant à travers la couche d'AlGaN (8) et dans la couche de GaN (6) ; et en
remplissant au moins partiellement chaque tranchée avec ledit second matériau électriquement conducteur.

9. Procédé selon la revendication 8, comprenant les étapes consistant à :
éliminer au moins une partie du premier matériau électriquement conducteur dudit au moins l'un des contacts pour former une ouverture dans la partie contact ohmique, l'ouverture exposant une partie de la surface principale ;
former la tranchée dans la partie de la surface principale exposée par l'ouverture dans la partie contact ohmique ; et
remplir au moins partiellement la tranchée et l'ouverture dans la partie contact ohmique avec ledit second matériau électriquement conducteur.

10. Procédé selon la revendication 9, dans lequel la partie du premier matériau électriquement conducteur du au moins l'un desdits contacts qui est éliminée pour former ladite ouverture dans la partie contact ohmique comprend une partie centrale dudit contact, et dans lequel après ledit remplissage au moins partiel de la tranchée et l'ouverture dans la partie contact ohmique avec ledit second matériau électriquement conducteur, la partie centrale est sensiblement entourée par la partie contact ohmique (18) lorsqu'elle est regardée depuis le dessus de la surface principale.
